# EUROPEAN PATENT SPECIFICATION

(11) **EP 0 416 461 B1**
(45) Date of publication and mention of the grant of the patent: **10.01.1996**
(21) Application number: 90116625.6
(22) Date of filing: 30.08.1990
(51) Int. Cl.: H05K 1/03

(54) **Material for molding printed circuit board and printed circuit board using said material**
Material zum Giessen einer gedruckten Schaltplatte und gedruckte Schaltplatte unter Verwendung dieses Materials
Matériau pour le moulage de plaque à circuit imprimé et plaque à circuit imprimé utilisant ce matériau

(30) Priority: 04.09.1989 JP 227561/89
(43) Date of publication of application: 13.03.1991
(73) Proprietor: IDEMITSU KOSAN CO., LTD., Tokyo (JP)
(72) Inventor: Nakano, Akikazu, Semboku-gun, Osaka (JP)
(74) Representative: Türk, Gille, Hrabal, Leifert

(56) References cited:
- EP-A- 0 210 615
- EP-A- 0 307 488
- PATENT ABSTRACTS OF JAPAN vol. 13, no. 328 (C-621)24 July 1989;& JP-A-1108244
- DATABASE WPIL Section Ch, Week 1990, 3 April 1990 Derwent Publications Ltd.,London, GB; Class A, AN 90-145159;& JP-A-2092947
- DATABASE WPIL Section Ch, Week 4889, 23 October 1989 Derwent Publications Ltd., London, GB; Class A, AN 90-017299;& JP-A-1265588

## Description

### Field of the Invention

The present invention relates to a printed circuit board used for electric and electronic fields, and materials and their use for molding the printed circuit board.

### Description of the Related Arts

Composite sheets prepared by combining thermosetting resins such as epoxy resin, phenolic resin, unsaturated polyester resin with a base material such as paper, glass fibers, synthetic fibers have been widely used. Such composite base materials are excellent in electrical insulation properties and the demand for the material has been greatly increasing in electric and electronic fields. However, these composite base materials of thermosetting resins require to use solvent such as styrene monomer during molding, resulting in bad work environment. Further, there are some problems, for example, they generally require several to several tens minutes of molding times to thermoset, or they are not always suitable to be used as multilayer printed circuit board used in a field wherein high performance operation is required, for example, in computer, because of high dielectric constant and dielectric dissipation factor.

As multilayer printed circuit board used in a field wherein high performance operation is required, for example, in computer, printed circuit boards using fluorinated polyethylene resin or polyphenylene oxide (PPO) as an electrical insulating base have been rapidly developed. However, the fluorinated polyethylene resin, which is extremely difficult to be molded, is much expensive. PPO has poor heat resistance. It is proposed to improve heat resistance by impregnating PPO with cross-linkable resin and crosslinking. However, it requires troublesome operations. On the other hand, printed circuit board using polyphenylene sulfide (PPS), which is a thermoplastic resin, as a base material has been studied to improve production efficiency. However, dielectric constant of PPS is so high that PPS cannot be used as multilayer printed circuit for boards for which high performance operation is required.

JP-A-01 108 244 discloses a material wherein mainly syndiotactic styrene polymer, with at least 50% of racemic pentad, can be mixed with 0.01-10 parts by weight of asbestos, as a fibrous filler, and/or antimony oxide, as a flame retardant.

Accordingly, the present inventors have studied intensively to develop materials for molding circuit boards which are excellent in dielectric properties, moldability, mechanical strength and heat resistance, and are suitably used in the field wherein high performance operation is required.

### Summary of the Invention

As the result, it has been found that a styrene polymer having a high degree of syndiotactic configuration, which the present inventors' group have succeeded to develop, can be used to solve the above problems. The present invention has been established based on such findings.

That is, the present invention provides materials for molding printed circuit boards which comprise 100 parts by weight of a polymer composition consisting of 100 to 20% by weight of a styrene polymer having such syndiotactic configuration that the proportion of racemic pentad is at least 30% and having a crystallinity of 25 to 65% (a) and 0 to 80% by weight of a fibrous filler (b), 0 to 40 parts by weight of a flame retardant (c) and 0 to 15 parts by weight of an auxiliary flame retardant (d). The present invention also provides printed circuit board which comprises a metal layer formed on a molded product consisting of said materials.

### Description of the Preferred Embodiments

As mentioned above, the materials for molding the printed circuit board of the present invention contain components (a) to (d), wherein the component (a) is styrene polymer having the high degree of syndiotactic configuration as defined above.

Here, the styrene polymer which has a high degree of syndiotactic configuration means that its stereochemical structure is a high degree of syndiotactic configuration, i.e., the stereostructure in which phenyl groups or substituted phenyl groups as side chains are located alternately in opposite directions relative to the main chain consisting of carbon-carbon bonds. Tacticity is quantitatively determined by the nuclear magnetic resonance method (¹³C-NMR method) using carbon isotope. The tacticity as determined by the ¹³C-NMR method can be indicated in terms of proportions of structural units continuously connected to each other, i.e., a diad in which two structural units are connected to each other, a triad in which three structural units are connected to each other and a pentad in which five structural units are connected to each other. The styrene polymers having a high degree of syndiotactic configuration mean polystyrenes having such a high degree of syndiotactic configuration that the proportion of racemic pentad is at least 30% and preferably at least 50%, e.g. poly(alkylstyrene), poly(halogenated styrene), poly(alkoxystyrene), poly(vinyl benzoate ester), hydrogenated polymers thereof and mixture thereof, or copolymers containing these structural units. Here, the poly(alkylstyrene) includes poly(methylstyrene), poly(ethylstyrene), poly(propylstyrene) and poly(butylstyrene), poly(phenylstyrene), poly(vinylnaphthalene), poly(vinylstyrene), poly(acenaphthylene), and the poly(halogenated styrene) includes poly(chlorostyrene), poly(bromostyrene) and poly(fluorostyrene). The poly(alkoxystyrene) includes poly(methoxystyrene) and poly(ethoxystyrene). Of these, a particularly preferred styrene polymer includes polystyrene, poly(p-methylstyrene), poly(m-methylstyrene), poly(p-tert-butylstyrene), poly(p-chlorostyrene), poly(m-chlorostyrene), poly(p-fluorostyrene), and further a copolymer of styrene and p-methylstyrene (see, Japanese Patent Application Laid-Open No. 187708/1987).

Comonomer in the styrene polymer includes, in addition to the above monomer of styrene polymer, olefin monomer such as ethylene, propylene, butene, hexene, octene; diene monomer such as butadiene, isoprene; cyclic diene monomer or polar vinyl monomer such as methyl methacrylate, maleic anhydride, acrylonitrile.

The styrene polymer usually has a weight average molecular weight of 10,000 to 1,000,000, preferably, 50,000 to 800,000, and more preferably, 100,000 to 700,000.

Viscosity of the styrene polymer is not particularly limited, but those having melt viscosity of not less than 100 and not more than 10,000 poise at 300°C and at shear rate of 1,000/sec are suitable to attain the object of the present invention. Further, crystallinity, crystal structure and crystal form are not particularly limited. The product using styrene polymer with crystallinity of 25 to 65% is particularly excellent in heat resistance, free from warp or deformation caused by heat, and possesses resistance to soldering such as flow soldering. Thus, they are particularly suitable for application which requires heat resistance. The crystallinity is more preferably 30 to 65%, most preferably 40 to 60%. Dielectric constant does not change by crystallinity. The crystallinity is measured by differential scanning calorimeter (DSC).

For example, the above styrene polymer having syndiotactic configuration can be produced by polymerization of styrene monomers (monomers corresponding to the above styrene polymers) using titanium compound and a condensation product of water and trialkylaluminum as a catalyst or in the presence of inert hydrocarbon solvent (see, Japanese Patent Application Laid-Open No. 187708/1987). Poly(halogenated alkylstyrene) and hydrogenated polymer thereof may be obtained according to the method described in Japanese Patent Application Laid-Open Nos. 46912/1989 and 178505/1989, respectively.

The materials for molding printed circuit board of the present invention contain fibrous filler as a component (b). Such fibrous filler includes glass fiber, carbon fiber, whisker of boron, silica, silicon carbide and the like, alumina fiber, ceramic fiber, for example, gypsum fiber, potassium titanate fiber, magnesium sulfate fiber, magnesium oxide fiber, organic synthetic fibers, for example, aromatic polyamide fibers, aramid fibers, polyimide fibers and the like. Particularly, glass fiber and carbon fiber are preferred. The shape of the fibrous filler is not particularly limited, for example, chopped strand, chopped fiber, mat of continuous fiber, woven fabric, knit fabric, swirl-like laminate, needle-punched swirl-like laminate, powder, milled fibers and the like may be employed. The above fibrous fillers may be used alone or in a combination of two or more of them. When conductive inorganic fillers are used, insulating layer may be provided.

As for the compounding ratio of components (a) and (b) in the materials for molding printed circuit board of the present invention, 20 to 100% by weight (wt%), preferably, 30 to 100 wt%, more preferably, 50 to 90 wt% of the component (a) and 0 to 80 wt%, preferably, 0 to 70 wt%, more preferably, 10 to 50 wt% of the component (b) are compounded. When the compounding ratio of the fibrous filler exceeds 80 wt%, dielectric constant is high like that of the fibrous filler alone, and the fibrous filler may not be sufficiently covered with the component (a). Accordingly, bending strength is too low to be measured. Further, the product can not be kneaded during melt molding and can not be injection molded. When styrene polymer with crystallinity of at least 25% is used as the component (a), it is desirable to compound 20 to 95 wt%, preferably, 30 to 95 wt%, more preferably, 50 to 90 wt% of the component (a) and 5 to 80 wt%, preferably, 5 to 70 wt%, more preferably, 10 to 50 wt% of the component (b).

Since flame resistance is required for the materials for molding the printed circuit board of the present invention, 5 to 35 parts by weight of flame retardant (c) and 0 to 15 parts by weight of auxiliary flame retardant (d) are added.

As a flame retardant, those of various kinds may be used. Among them, halogen flame retardants, phosphorus flame retardants are preferred. The halogen flame retardant includes, for example, oligomer such as tetrabromobisphenol A, tetrabromophthalic anhydride, hexabromobenzene, tribromophenylallyl ether, pentabromotoluene, pentabromophenol, tribromophenyl-2,3-dibromopropyl ether, tris(2,3-dibromopropyl)phosphate, tris(2-chloro-3-bromopropyl)-phosphate, octabromodiphenyl ether, decabromodiphenyl ether, octabromobiphenyl, pentachloropentacyclodecane, hexabromocyclodecane, hexachlorobenzene, pentachlorotoluene, hexabromobiphenyl, decabromobiphenyl, decabromobiphenyl oxide, tetrabromobutane, decabromodiphenyl ether, hexabromophenyl ether, ethylene-bis-(tetrabromophthalimide), tetrachlorobisphenol A, tetrabromobisphenol A, tetrachlorobisphenol A or tetrabromobisphenol A; halogenated polycarbonate oligomer such as brominated polycarbonate oligomer; halogenated epoxy compound; halogenated polystyrene such as polychlorostyrene, polytribromostyrene; poly(dibromophenylene oxide), bis(tribromophenoxy)ethane and the like.

On the other hand, phosphorus flame retardant includes, for example, ammonium phosphate, tricresyl phosphate, triethyl phosphate, acidic phosphate ester, triphenylphosphine oxide.

Among them, polytribromostyrene, poly(dibromophenylene oxide), decar bomodiphenylether, bis(tribromophenoxy)ethane, ethylene-bis-(tetrabutylphthalimide), tetrabromobisphenol A, brominated polycarbonate oligomer are particularly preferred as flame retardants.

5 to 35 parts by weight of the above flame retardants is compounded with 100 parts by weight (in total) of the above components (a) and (b). When more than 40 parts by weight of the flame retardant is compounded, flame resistance does not increase in proportion to the compounding ratio, or rather other mechanical properties may be undesirably lowered.

In the present invention, it is preferable to use auxiliary flame retardant (d) as well as the above flame retardant. Using both agents, the objective effect can be sufficiently provided.

The auxiliary flame retardants include those of various kinds, for example, antimony auxiliary flame retardants such as antimony trioxide, antimony pentaoxide, sodium antimonate, metallic antimony, antimony pentachloride, antimony trisulfide, antimony pentasulfide. In additions, zinc borate, barium metaborate, zirconium oxide and the like may be used. Among them, antimony trioxide is particularly preferred.

Such flame retardant may be compounded in the ratio of 0 to 15 parts by weight, preferably, 2 to 10 parts by weight to 100 parts by weight (in total) of the above components (a) and (b). When more than 15 parts by weight is compounded, the effect is not heightened in proportion to the amount, or rather disadvantageously degrading the other properties, particularly increasing dielectric constant.

Further, in the present invention, tetrafluoroethylene polymer can be added to prevent melt dropping. Tetrafluoroethylene polymer includes, for example, in addition to tetrafluoroethylene homopolymer (polytetrafluoroethylene), copolymer of tetrafluoroethylene and hexafluoropropylene, and tetrafluoroethylene copolymer containing small amount of copolymerizable ethylenic unsaturated monomer. As such tetrafluoroethylene polymer, those with fluorine content of 65 to 76 wt%, preferably, 70 to 76 wt% are used.

Tetrafluoroethylene polymer is compounded in the ratio of 0.003 to 10 parts by weight, preferably, 0.02 to 2 parts by weight, more preferably, 0.1 to 2 parts by weight to 100 parts by weight (in total) of the above components (a) and (b).

In the materials for molding the printed circuit board of the present invention, the above components (a) to (d) may be compounded in the above range. However, in multi-layer printed circuit board used in the field requiring high performance operation, dielectric constant is required to be not more than 3.5. Accordingly, the compounding ratio should be selected to keep dielectric constant below 3.5.

The materials for molding the printed circuit board of the present invention contain the above components (a) to (d) and, in some cases, tetrafluoroethylene polymer in the above ratio, and further, additives such as antioxidants, inorganic fillers, antistatic agents, thermoplastic resins, rubber-like elastic body may be added. Thermoplastic resins include those compatible with styrene polymers having syndiotactic configuration and those incompatible with them.

For example, styrene polymer having atactic configuration, styrene polymer having isotactic configuration, polyphenylene ether and the like may be usually compatible with the above styrene polymer having syndiotactic configuration, and provide molded product with excellent mechanical properties.

The incompatible resins include, for example, polyolefin such as polyethylene, polypropylene, polybutene, polypentene; polyester such as polyethylene terephthalate, polybutylene terephthalate, polyethylene naphthalate; polyamide such as nylon-6, nylon-6,6; polythioether such as polyphenylene sulfide, polycarbonate, polyarylate, polysulfone, polyetherketone, polyethersulfone, polyimide, halogenated vinyl polymer, acrylic polymer such as polymethyl methacrylate, polyvinyl alcohol, styrene-maleic anhydride copolymer (SMA), that is, those other than the above compatible resins, and cross-linked resins containing the above compatible resins.

The above materials for molding the printed circuit board may be molded by the optional methods for molding to produce base material for printed plate boards, and metallic layer is formed thereon to provide printed circuit board of the present invention.

As the process for molding base material for printed plate board, optional methods can be employed, for example, injection molding, compression molding with heating, molding for extruded continuous sheet and the like may be preferable from the viewpoint of productivity. For molding, melt temperature is in the range from melting point of styrene polymer (component (a)) to the temperature of 80°C higher than the melting point or 350°C. When injection molding is employed, the mold temperature is optional, but in the range from 100°C to melting point of styrene polymer, preferably, 120 to 200°C, more preferably, 130 to 190°C.

The shape of the resulting molded product is optional, for example, sheet or three dimensional product having boss, rib, connector and the like.

The process, wherein the fibrous filler (the component (b)) and the component (a) are melt kneaded, continuously extruded and molded while metallic foil is laminated thereon, and the resultant is laminated between rolls, provides extremely good production efficiency.

The thickness of the base material for printed plate board is optionally determined as needed, but generally, those described in JIS standards are preferred.

Metal layer is formed on thus molded base material. As such metal, copper, nickel, aluminum, tin, gold, silver, zinc and the like may be used. The metal layer may be formed by various kinds of processes, for example, a process which comprises laminating metallic foil by fusing or using adhesives, and etching the metallic foil (subtractive process), a process wherein circuit is directly metallized (additive process), the foil stamping process wherein circuit foils are laminated, the vacuum deposition process, the sputtering process and the like. As the adhesives used in the subtractive process, any kinds of adhesives can be used. It is preferable to use thermosetting adhesives with heat resistance, epoxy adhesives and the like.

When these metallic foils are formed, particularly, by injection molding or compression molding with heat, the metallic foils are placed inside the mold, and circuit is formed on the molded product at the same time of molding to produce three dimensional printed circuit board.

The thickness of the above metal layer is optionally determined as needed. But generally, several 10⁻¹ micrometers of metallized layer to several millimeters of metallic foil are preferable.

Since the material for molding the printed circuit board according to the present invention is excellent in dielectric properties, it is suitable for multi-layer printed circuit board used in the field wherein high performance operation is required. Further because of good moldability, production cost may be reduced. When styrene polymer with crystallinity within a certain range is used, printed circuit board particularly excellent in heat resistance and having anti-soldering (e.g., flow soldering) properties may be obtained.

Accordingly, the present invention may be effectively utilized for production of printed circuit board used in electric and electronic fields.

The present invention will be described in more detail with reference to examples and comparative examples.

Examples 1 to 4, 9 to 12, 17 and 18 are not covered by the claims, but are useful for understanding the invention.

### Production Example 1

### (1) Preparation of contact product of trimethylaluminum and water

In a 500-milliliter glass vessel which had been purged with argon were placed 17.8 g (71 mmol) of copper sulfate pentahydrate (CuSO₄·5H₂O), 200 ml of toluene, and 24 ml (250 mmol) of trimethylaluminum, which were then reacted at 40°C for 8 hours. Then, solids were separated from the reaction mixture, and the toluene was distilled away from the solution as obtained above under reduced pressure at room temperature to obtain 6.7 g of a contact product. The molecular weight of the contact product as determined by the freezing point depression method was 610.

### (2) Production of Styrene Polymer with Weight Average Molecular Weight (Mw) of 180,000

In a 2.0 liter reactor were placed 1 L (L=liter) of purified styrene, 10 mmol as aluminum atom of the contact product obtained in (1) above, 60 mmol of triisobutylaluminum, 0.075 mmol of pentamethylcyclopentadienyltitanium trimethoxide, and polymerization was carried out at 90°C for one hour. After the reaction was over, the catalyst component was decomposed with a solution of sodium hydroxide in methanol, then the product was repeatedly washed with methanol, dried to give 268 g of the polymer. The weight average molecular weight of the polymer measured by gel permeation chromatography using 1,2,4-trichlorobenzene as a solvent at 130°C was 180,000, and the value, (weight average molecular weight)/(number average molecular weight) of this polymer was 2.53. The polymer was confirmed to be a polymer having syndiotactic configuration by determination of melting point and ¹³C-NMR analysis.

### Production Example 2

### Production of Styrene Polymer having Mw of 389,000

In a 2.0 liter reactor were placed 1 L of purified styrene, 5 mmol as aluminum atom of the contact product obtained in (1) above, 5 mmol of triisobutylaluminum, 0.025 mmol of pentamethylcyclopentadienyltitanium trimethoxide, and polymerization was carried out at 90°C for 5 hours. After the reaction was over, the catalyst component was decomposed with a solution of sodium hydroxide in methanol, then the product was repeatedly washed with methanol, dried to give 308 g of the polymer. The weight average molecular weight of the polymer measured by gel permeation chromatography using 1,2,4-trichlorobenzene as a solvent at 130°C was 389,000, and the value, (weight average molecular weight)/(number average molecular weight) of this polymer was 2.64. The polymer was confirmed to be a polymer having syndiotactic configuration by determination of melting point and ¹³C-NMR analysis.

### Production Example 3

### Production of Styrene Polymer having Mw of 592,000

Polymerization was carried out at 70°C for 3 hours in a 2.0 liter reactor using 1 L of purified styrene, 7.5 mmol as aluminum atom of the contact product obtained in (1) above, 7.5 mmol of triisobutylaluminum, 0.038 mmol of pentamethylcyclopentadienyltitanium trimethoxide. After the reaction was over, the catalyst component was decomposed with a solution of sodium hydroxide in methanol, then the product was repeatedly washed with methanol, dried to give 588 g of the polymer. The weight average molecular weight of the polymer measured by gel permeation chromatography using 1,2,4-trichlorobenzene as a solvent at 130°C was 592,000, and the value, (weight average molecular weight)/(number average molecular weight) of this polymer was 2.81. The polymer was confirmed to be a polymer having syndiotactic configuration by determining melting point and ¹³C-NMR analysis.

### Production Example 4

### Production of Styrene Polymer having Mw of 802,000

Polymerization was carried out at 90°C for 5 hours in a 2.0 liter reactor using 1 L of purified styrene, 5 mmol as aluminum atom of the contact product obtained in (1) above, 5 mmol of triisobutylaluminum, 0.025 mmol of pentamethylcyclopentadienyltitanium trimethoxide. After the reaction was over, the catalyst component was decomposed with a solution of sodium hydroxide in methanol, then the product was repeatedly washed with methanol, dried to give 477 g of the polymer. The weight average molecular weight of the polymer measured by gel permeation chromatography using 1,2,4-trichlorobenzene as a solvent at 130°C was 802,000, and the value, (weight average molecular weight)/(number average molecular weight) of this polymer was 2.24. The polymer was confirmed to be a polymer having syndiotactic configuration by determining melting point and ¹³C-NMR analysis.

### Example 1

Ten kilograms of syndiotactic polystyrene obtained in Production Example 1 was melt extruded using a single screw extruder (cylinder temperature was set at 280°C) to be molded into pellets. The pellets were fed into a hot press (set temperature: 300°C) and after one-minute pre-heating, 25 kg/cm of pressure was applied, heated for 3 minutes, fed in a cold press, cooled for 5 minutes while 50 kg/cm of pressure was applied to give a product of 2.0 mm thickness, which was used as a base material for printed plate board.

Copper foil of 70 µm thickness for print plate board on which epoxy adhesive was applied was laminated on the base material for printed plate board to prepare copper-clad printed plate board.

Dielectric properties test was carried out using the copper-clad printed plate obtained above according to JIS-C-6481, and bending strength was measured using specimens cut from the base material for printed plate board according to JIS-K-7201. The results are shown in Table 2.

### Examples 2 to 4

Powder of syndiotactic polystyrene obtained in the above Production Examples 2 to 4 and glass fibers were compounded as shown in Table 1, and blended by a Henschel mixer. The resulting blend was molded into pellets using a twin screw extruder (cylinder temperature was set at 300°C). The resulting pellets were injection molded at set cylinder temperature of 300°C and mold temperature of 150°C, providing a product of 2.0 mm thickness, which was used as a base material for printed plate board.

A copper foil for printed plate board of 70 µm thickness with thermosetting adhesives coated thereon was laminated onto this base material for printed plate board, and the resultant was fed into a hot press (set temperature: 130°C), laminated to prepare copper-clad printed plate board.

Dielectric properties test was carried out according to JIS-K-6481 using the above obtained copper-clad printed plate board, and bending strength was measured using specimens cut out from the base material for printed plate board according to JIS-K-7201. The results are shown in Table 2.

### Examples 5 to 7 and Reference Examples 1 and 2

Powder of syndiotactic polystyrene obtained in the above Production Example 3, glass fiber, flame retardant and auxiliary flame retardant were compounded as shown in Table 1, and blended in a Henschel mixer. The blend was melt extruded using a uniaxial extruder with T die mounted at the tip (cylinder temperature was set at 300°C). The resultant was slowly cooled, molded into a sheet of 30 cm width and 3.2 mm thickness and cut to give a product, which was used as a base material for printed plate board.

A copper foil for printed plate board of 70 µm thickness with thermosetting adhesives coated thereon was laminated onto this base material for printed plate board, and the resultant was fed into a hot press (set temperature: 130°C), laminated to prepare copper-clad printed plate board.

Dielectric properties test was carried out according to JIS-K-6481 using the above obtained copper-clad printed plate board, and flexural strength was measured using specimens cut out from the base material for printed plate board according to JIS-K-7201. The results are shown in Table 2.

### Example 8

In the same manner as that in Example 5, except that the thickness of the sheet was 0.5 mm, a product was obtained which was used as a base material for printed plate board.

In the same manner as that in Example 5, copper foil for printed plated board was laminated on this base material for printed plate board to prepare copper-clad printed plate board. Dielectric properties test was carried out using this copper-clad printed plate board according to JIS-C-6481. The results are shown in Table 2.

### Comparative Example 1

The procedure in Example 4 was repeated, except that PPS (manufactured by Phillips Petroleum, trade name: Ryton R-7) was injection molded at cylinder temperature of 330°C and mold temperature of 150°C. The results of the measurement of dielectric properties and bending strength are shown in Table 2.

### Comparative Example 2

The results of the measurement of dielectric constant of glass-epoxy composite plate board (manufactured by Toshiba Chemical, trade name: Decolite TLS-751) are shown in Table 2.

### Comparative Example 3

In the same manner as in Example 4, using the composition shown in Table 1, printed plate board was prepared. The results of measurement of dielectric properties and bending strength are shown in Table 2.

### Comparative Example 4

The results of measurement of dielectric constant of Teflon plate board (manufactured by Mitsui-Du Pont Fluorochemical Co., Ltd.) are shown in Table 2.

### Examples 9 to 18 and Comparative Examples 5 and 6

Powdery syndiotactic polystyrene obtained in Production Examples 1 to 3, glass fiber, 0.5 parts of aluminum p-(t-butyl)benzoate (trade name: PTBBA-AL, manufactured by Dainihon Ink Kagaku Kogyo Co., Ltd.) as a nucleating agent and other additives were compounded as shown in Table 3, blended in a Henschel mixer. The blend was molded into pellets using a biaxial extruder (cylinder temperature of 300°C). The resulting pellets were injection molded at cylinder temperature of 300°C and mold temperature of 30 to 190°C to obtain a product of 3.2 mm thickness, which was used as a base material for a printed plate board.

Copper foil for printed plate board of 70 µm thickness covered with epoxy adhesive was laminated on this base material for printed plate board to prepare copper-clad printed plate board.

Using the copper-clad printed plate board obtained in the above, dielectric properties test was carried out according to JIS-K-6481, bending strength was measured using specimens cut out from the base material for printed plate board according to JIS-K-7201, heat deformation temperature was measured according to JIS-K-7207, and crystallinity was obtained by DSC measurement. The results are shown in Tables 3 and 4.

The chopped strands used in the above Examples, Comparative Examples, and Reference Examples are manufactured by Asahi Fiber Glass Co., Ltd. The flame retardant are as follows: Polytribromostyrene: Pyrocheck 68PB manufactured by Nissan Fero Co., Ltd.

Poly(dibromophenyleneoxide): GLC PO-64P manufactured by Great Lake Co., Ltd.

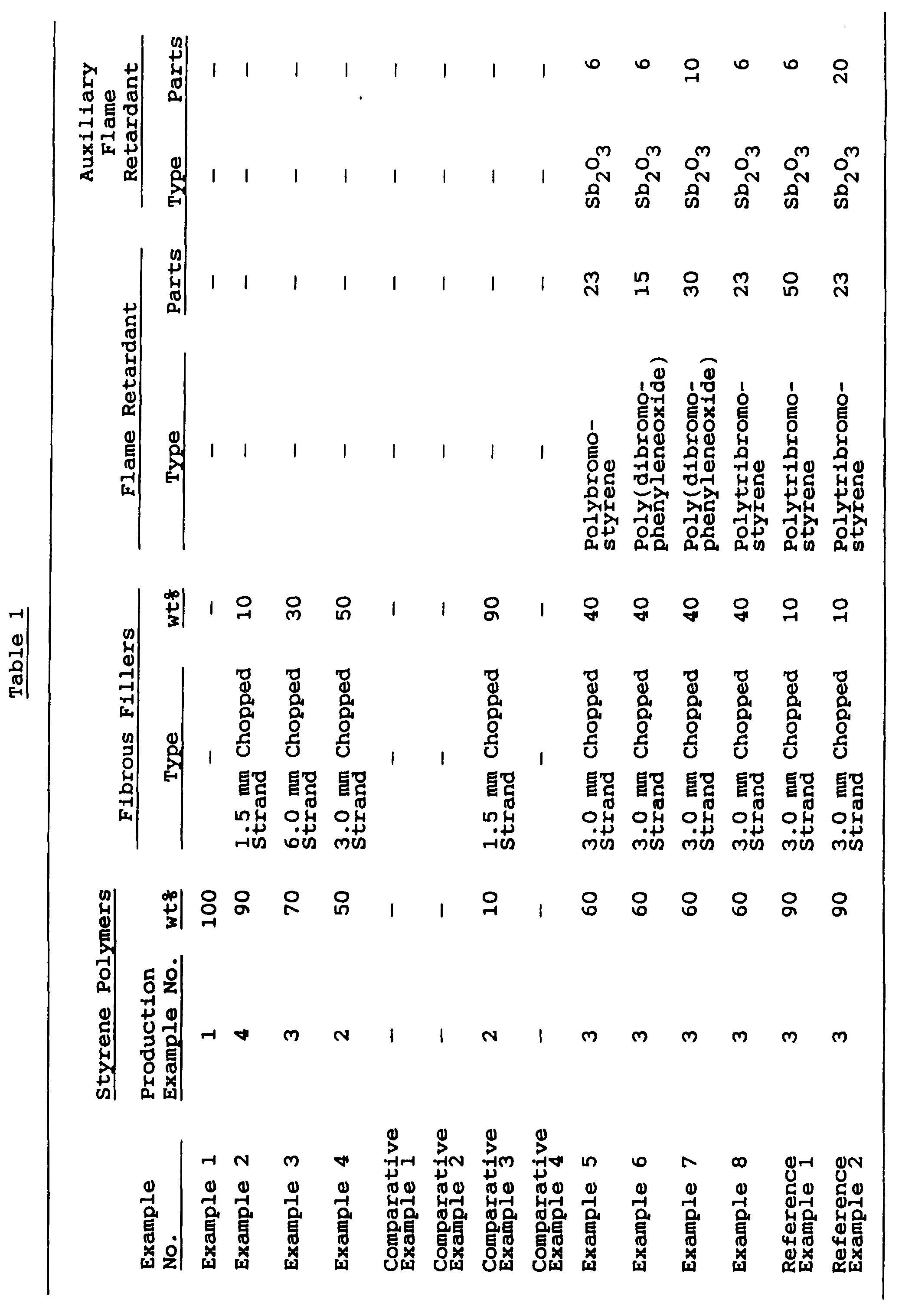

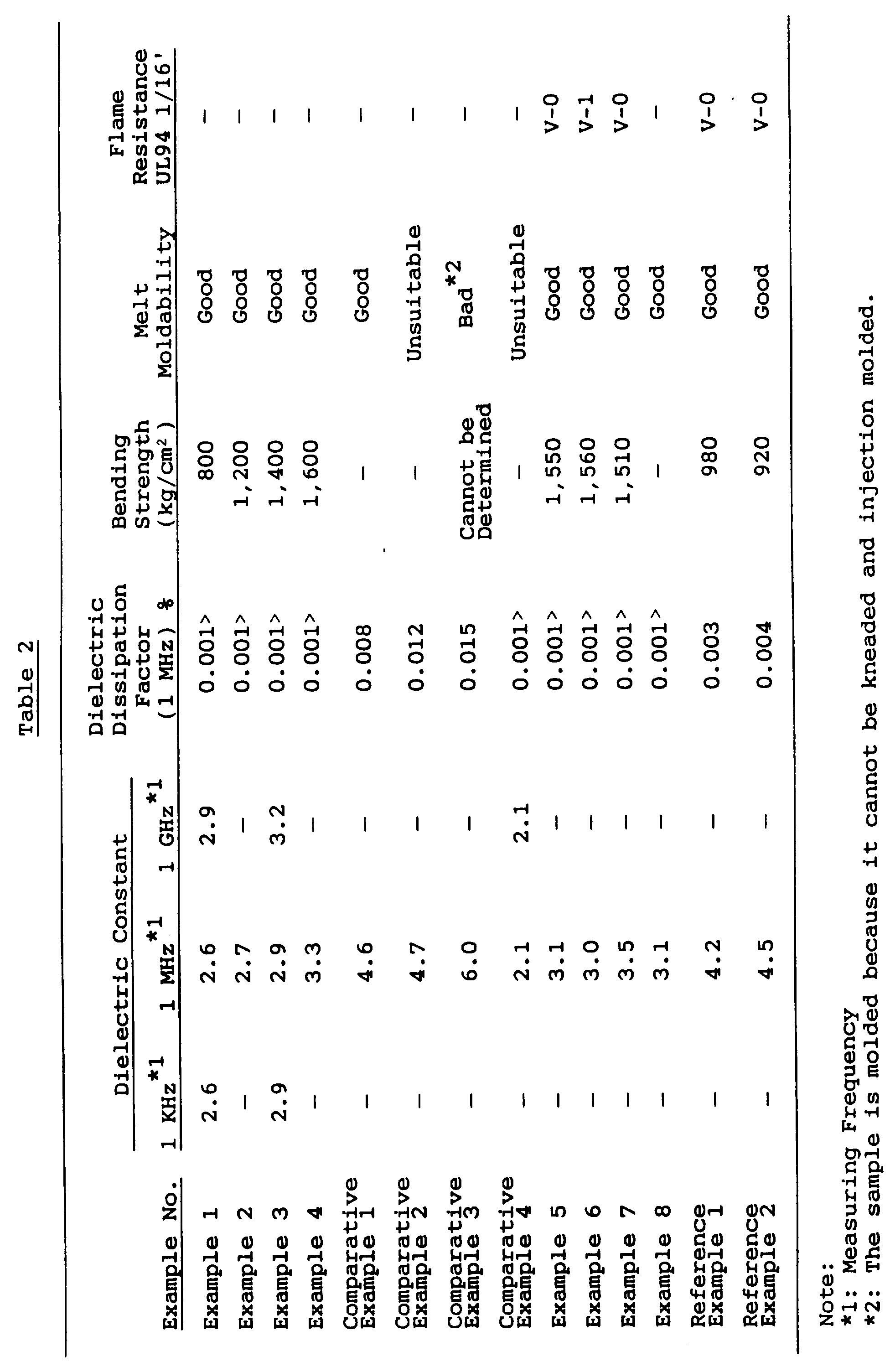

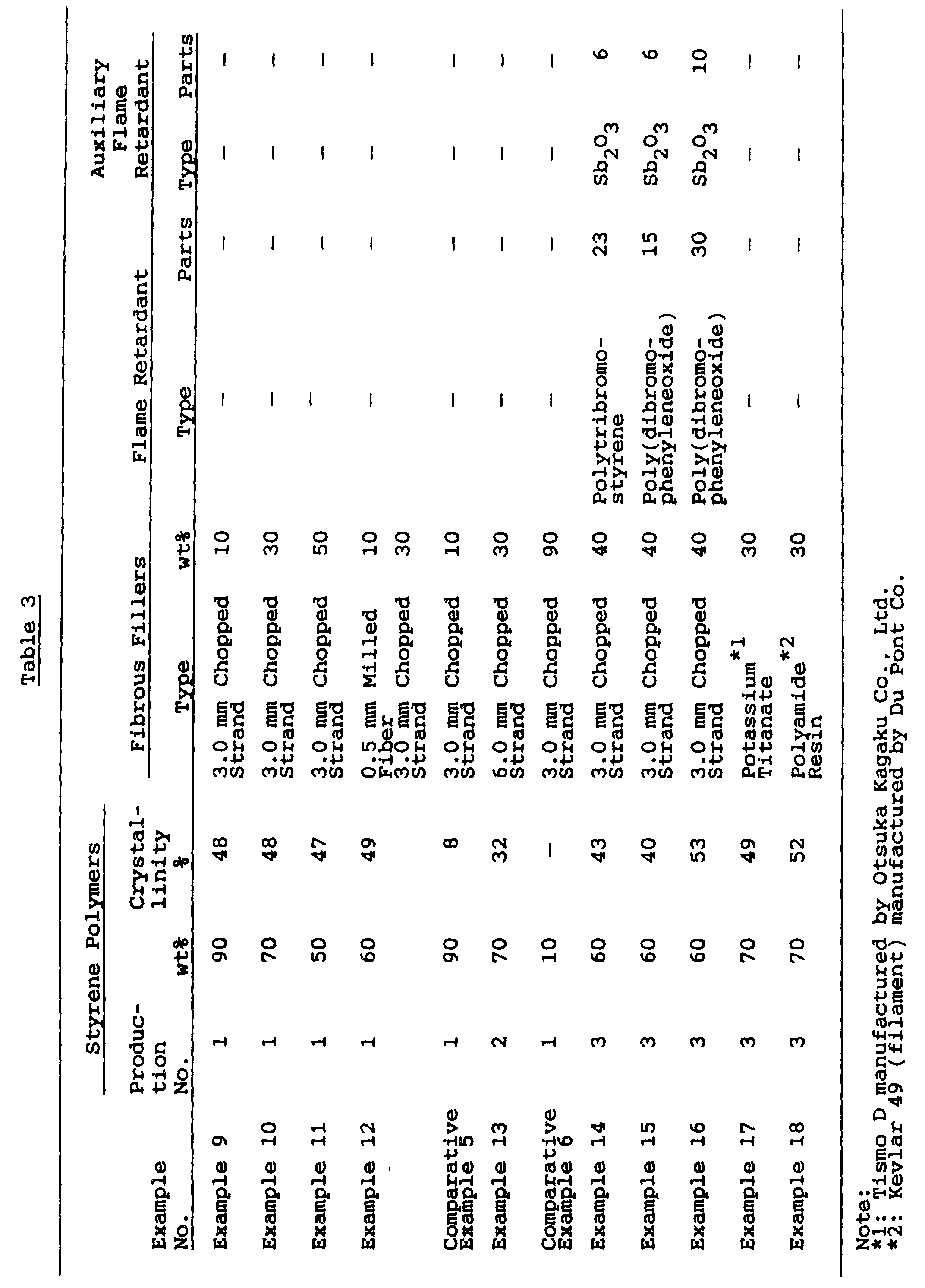

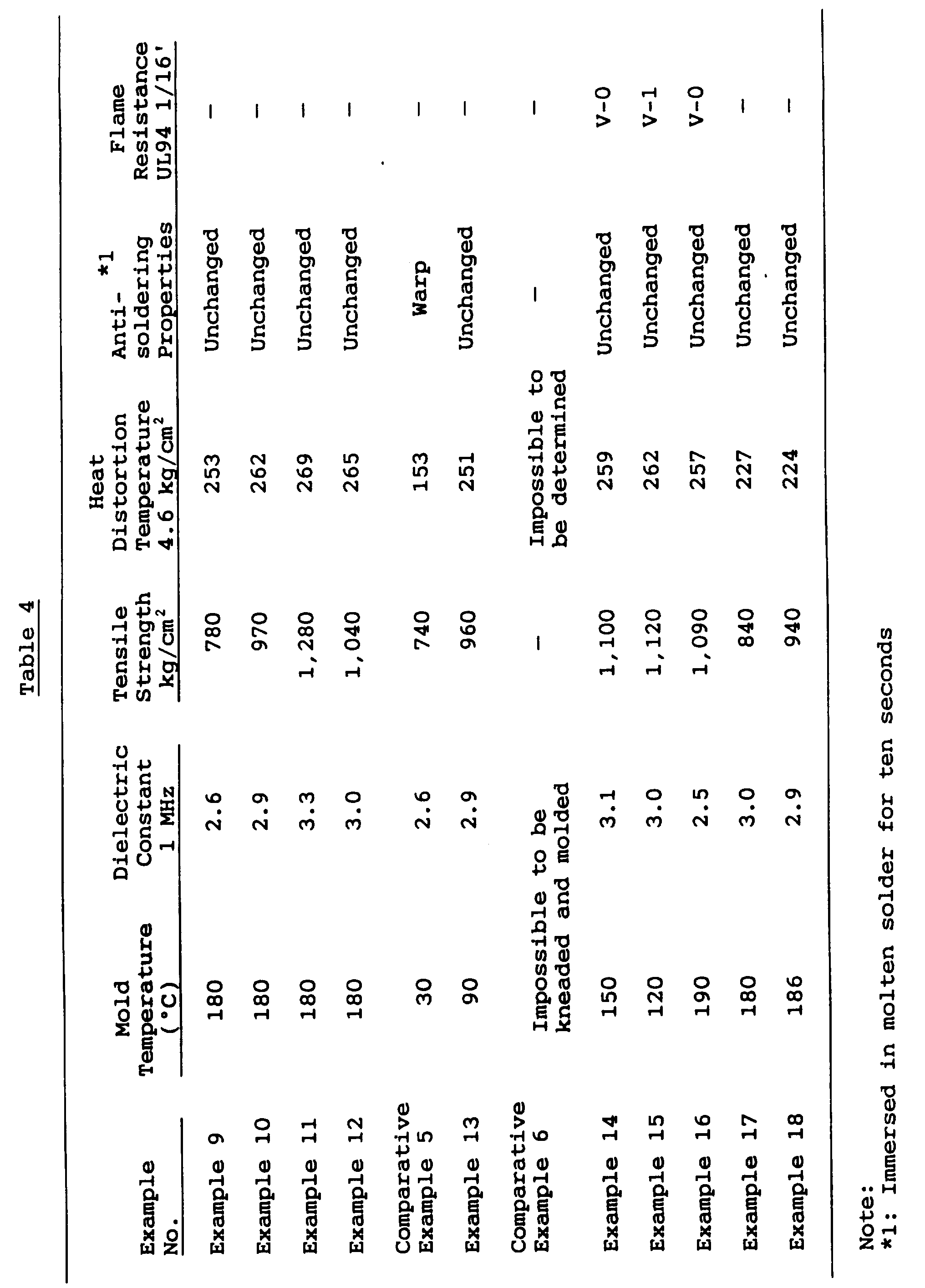

## Claims

1. A material for molding printed circuit board, which is prepared by compounding 100 parts by weight of polymer composition consisting of 100 to 20% by weight of styrene polymers having such syndiotactic configuration that the proportion of racemic pentad is at least 30% and having a crystallinity of 25 to 65% (a) and 0 to 80% by weight of fibrous fillers (b) with 5 to 35 parts by weight of flame retardant (c) and 0 to 15 parts by weight of auxiliary flame retardant (d).

2. The material for molding printed circuit board according to Claim 1, wherein 30 to 100% by weight of the component (a) and 0 to 70% by weight of the component (b) are compounded.

3. The material for molding printed circuit board according to Claim 1, wherein 50 to 90% by weight of the component (a) and 10 to 50% by weight of the component (b) are compounded.

4. The material for molding printed circuit board according to Claim 1, which is prepared by compounding 100 parts by weight of polymer composition consisting of 95 to 20% by weight of styrene polymers having such syndiotactic configuration that the proportion of racemic pentad is at least 30% (a) and 5 to 80% by weight of fibrous fillers (b) with 5 to 35 parts by weight of flame retardant (c) and 0 to 15 parts by weight of auxiliary flame retardant (d).

5. The material for molding printed circuit board according to Claim 1, which is prepared by compounding 100 parts by weight of polymer composition consisting of 90 to 50% by weight of styrene polymers having such syndiotactic configuration that the proportion of racemic pentad is at least 30% (a) and 10 to 50% by weight of fibrous fillers (b) with 5 to 35 parts by weight of flame retardant (c) and 0 to 15 parts by weight of auxiliary flame retardant (d).

6. The material for molding printed circuit board according to Claim 4, wherein 100 parts by weight of the components (a) and (b) are compounded with 5 to 35 parts by weight of flame retardant (c) and 2 to 100 parts by weight of auxiliary flame retardant (d).

7. The material for molding printed circuit board according to Claim 1, which further contains tetrafluoroethylene polymer.

8. Use of the material of claim 1 for the production of a printed circuit board characterized in that the compounding ratio of the components (a) to (d) are selected so that the dielectric constant of the resulting multi-layer printed circuit board is not more than 3.5.

9. Use of the material of claim 1 for the production of a printed circuit board characterized in that the material further contains additives selected from antioxidants, inorganic fillers, antistatic agents, thermoplastic resins, rubber-like elastic bodies.

10. The printed circuit board which comprises a metal layer formed on the molded product consisting of the material according to Claim 1.

11. The printed circuit board according to claim 10, wherein 30 to 100% by weight of the component (a) and 0 to 70% by weight of the component (b) are compounded in the material.

## Patentansprüche

1. Material zum Formen von Leiterplatten, das hergestellt wird durch Vermischen von 100 Gewichtsteilen einer Polymerzusammensetzung, die besteht aus 100 bis 20 Gew.-% Styrolpolymeren mit einer solchen syndiotaktischen Konfiguration, daß der Anteil der racemischen Pentaden mindestens 30 % beträgt, und mit einer Kristallinität von 25 bis 65 % (a) und 0 bis 80 Gew.-% eines faserartigen Füllstoffes (b), mit 5 bis 35 Gewichtsteilen eines Flammschutzmittels (c) und 0 bis 15 Gewichtsteilen eines Hilfsflammschutzmittels (d) .

2. Material zum Formen von Leiterplatten nach Anspruch 1, worin 30 bis 100 Gew.-% der Komponente (a) und 0 bis 70 Gew.-% der Komponente (b) vermischt sind.

3. Material zum Formen von Leiterplatten nach Anspruch 1, worin 50 bis 90 Gew.-% der Komponente (a) und 10 bis 50 Gew.-% der Komponente (b) vermischt sind.

4. Material zum Formen von Leiterplatten nach Anspruch 1, das hergestellt wird durch Vermischen von 100 Gewichtsteilen einer Polymerzusammensetzung, die besteht aus 95 bis 20 Gew.-% Styrolpolymeren mit einer solchen syndiotaktischen Konfiguration, daß der Anteil der racemischen Pentaden mindestens 30 % beträgt, (a), und 5 bis 80 Gew.-% eines faserförmigen Füllstoffes (b), mit 5 bis 35 Gewichtsteilen eines Flammschutzmittels (c) und 0 bis 15 Gewichtsteilen eines Hilfsflammschutzmittels (d).

5. Material zum Formen von Leiterplatten nach Anspruch 1, das hergestellt wird durch Vermischen von 100 Gewichtsteilen einer Polymerzusammensetzung, die besteht aus 90 bis 50 Gew.-% Styrolpolymeren mit einer solchen syndiotaktischen Konfiguration, daß der Anteil der racemischen Pentaden mindestens 30 % beträgt, (a), und 10 bis 50 Gew.-% eines faserförmigen Füllstoffes (b) mit 5 bis 35 Gewichtsteilen eines Flammschutzmittels (c) und 0 bis 15 Gewichtsteilen eines Hilfsflammschutzmittels (d).

6. Material zum Formen von Leiterplatten nach Anspruch 4, worin 100 Gewichtsteile der Komponenten (a) und (b) mit 5 bis 35 Gewichtsteilen des Flammschutzmittels (c) und 2 bis 100 Gewichtsteilen des Hilfsflammschutzmittels (d) vermischt sind.

7. Material zum Formen von Leiterplatten nach Anspruch 1, das ferner ein Tetrafluorethylenpolymer enthält.

8. Verwendung des Materials nach Anspruch 1 für die Herstellung von Leiterplatten, dadurch gekennzeichnet, daß das Mischungsverhältnis der Komponenten (a) bis (d) so gewählt wird, daß die Dielektrizitätskonstante der resultierenden Mehrschichtleiterplatte nicht mehr als 3,5 beträgt.

9. Verwendung des Materials nach Anspruch 1 für die Herstellung von Leiterplatten, dadurch gekennzeichnet, daß das Material ferner Additive enthält, ausgewählt aus Antioxidationsmitteln, anorganischen Füllstoffen, antistatischen Mitteln, thermoplastischen Harzen, kautschukartigen elastischen Körpern.

10. Leiterplatte, die eine Metallschicht, gebildet auf dem geformten Produkt umfaßt, das aus dem Material nach Anspruch 1 besteht.

11. Leiterplatte nach Anspruch 10, worin 30 bis 100 Gew.-% der Komponente (a) und 0 bis 70 Gew.-% der Komponente (b) in dem Material vermischt sind.

## Revendications

1. Matériau pour moulage de carte de circuit imprimé, qui est préparé en mélangeant 100 parties en poids de composition polymère constituée de 100 à 20% en poids de polymère de styrène ayant une telle configuration syndiotactique que la portion de pentade racémique est d'au moins 30% et ayant une cristallinité de 25 à 65% (a), et de 0 à 80% en poids de charges fibreuses (b) avec 5 à 35 parties en poids d'ignifugeant (c) et de O à 15 parties en poids d'ignifugeant auxiliaire (d).

2. Matériau pour le moulage de carte de circuit imprimé selon la revendication 1, dans lequel on mélange de 30 à 100% en poids de composant (a) et 0 à 70% du composant (b).

3. Matériau pour le moulage de carte de circuit imprimé selon la revendication 1, dans lequel on mélange 50 à 90% en poids du composant (a) et 10 à 50% en poids du composant (b).

4. Matériau pour le moulage de carte de circuit imprimé selon la revendication 1, qui est préparé en mélangeant 100 parties en poids d'une composition polymère comprenant 95 à 20% en poids de polymère de styrène ayant une telle configuration syndiotactique que la proportion de pentade racémique est d'au moins 30% (a), et 5 à 80% en poids de charges fibreuses (b) avec 5 à 35 parties en poids d'ignifugeant (c) et 0 à 15 parties en poids d'ignifugeant auxiliaire.

5. Matériau pour le moulage de carte de circuit imprimé selon la revendication 1, qui est préparé en mélangeant 100 parties en poids de composition polymère comprenant 90 à 50% en poids de polymère de styrène ayant une telle configuration syndiotactique que la proportion de pentade racémique est d'au moins 30% (a), et 10 à 50% en poids de charges fibreuses (b) avec 5 à 35 parties en poids d'ignifugeant (c) et 0 à 15 parties en poids d'ignifugeant auxiliaire (d).

6. Matériau pour le moulage de carte de circuit imprimé selon la revendication 4, dans lequel 100 parties en poids des composants (a) et (b) sont mélangés avec 5 à 35 parties en poids d'ignifugeant (c) et 2 à 100 parties en poids d'ignifugeant auxiliaire (d).

7. Matériau pour le moulage de carte de circuit imprimé selon la revendication 1, qui contient en plus un polymère tétrafluoroéthylène.

8. Utilisation du matériau selon la revendication 1, pour la production d'une carte de circuit imprimé caractérisée en ce que le rapport de composition des composants (a) à (d) est choisi de sorte que la constante diélectrique de la carte de circuit imprimé multicouche résultante n'est pas supérieure à 3,5.

9. Utilisation du matériau selon la revendication 1, pour la production d'une carte de circuit imprimé caractérisé en ce que le matériau contient en plus des additifs choisi parmi les antioxydants, les charges inorganiques, les agents antistatiques, les résines thermoplastiques, les corps élastiques similaires au caoutchouc.

10. La carte de circuit imprimé qui est constituée d'une couche métallique formées sur le produit moulé constitué du matériau selon la revendication 1.

11. La carte de circuit imprimé selon la revendication 10, dans laquelle 30 à 100% en poids du composant (a) et 0 à 70% en poids du composant (b) sont mélangés dans le matériau.
